(19) Europäisches Patentamt

European Patent Office

Office européen des brevets

(11) **EP 1 615 274 A2**

(12) **EUROPEAN PATENT APPLICATION**

(43) Date of publication:
**11.01.2006 Bulletin 2006/02**

(51) Int Cl.:
**H01L 35/30** (2006.01)

(21) Application number: **05254225.5**

(22) Date of filing: **06.07.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **06.07.2004 JP 2004198968**

(71) Applicants:
• **Central Research Institute of Electric Power
Industry
Tokyo 100-8126 (JP)**
• **Hitachi Powdered Metals Co., Ltd.
Matsudo-shi,
Chiba 270-2295 (JP)**

(72) Inventors:
• **Kambe, Mitsuru/Ctr. Res. Inst. of El. Power Ind.
Komae-shi
Tokyo 201-8511 (JP)**
• **Shikata, Hideo
Matsudo-shi
Chiba 270-2295 (JP)**

(74) Representative: **Khan, Mohammed Saiful Azam et
al
Eric Potter Clarkson
Park View House
58 The Ropewalk
Nottingham, NG1 5DD (GB)**

(54) **Thermoelectric conversion module**

(57)     A thermoelectric conversion module for generating power by using a temperature difference and realizing a large-size module with soundness to improve substantial filling density of a thermoelectric semiconductor, including a sliding member having high heat conductivity intervening at least between a heating plate of a high-temperature heat source side and a heat source side electrode portion of a thermoelectric semiconductor and a coupling plate for coupling the heating plate to the cooling plate, wherein the thermoelectric semiconductors and the electrode portions are integrated by being sandwiched between the cooling plate and the heating plate via the sliding member, and the sliding member in the pressurized state accepts relative sliding between the sliding member and the heat source side electrode portion or the heating plate.

## Fig. 1

**Description**

BACKGROUND OF THE INVENTION

Field of the Invention

The present invention relates to a thermoelectric conversion module used for a thermoelectric conversion system of which heat source is waste heat of various kinds of industrial equipment and automobiles for instance. To describe it further in detail, the present invention relates to a technique for upsizing the thermoelectric conversion module.

Description of the Related Art

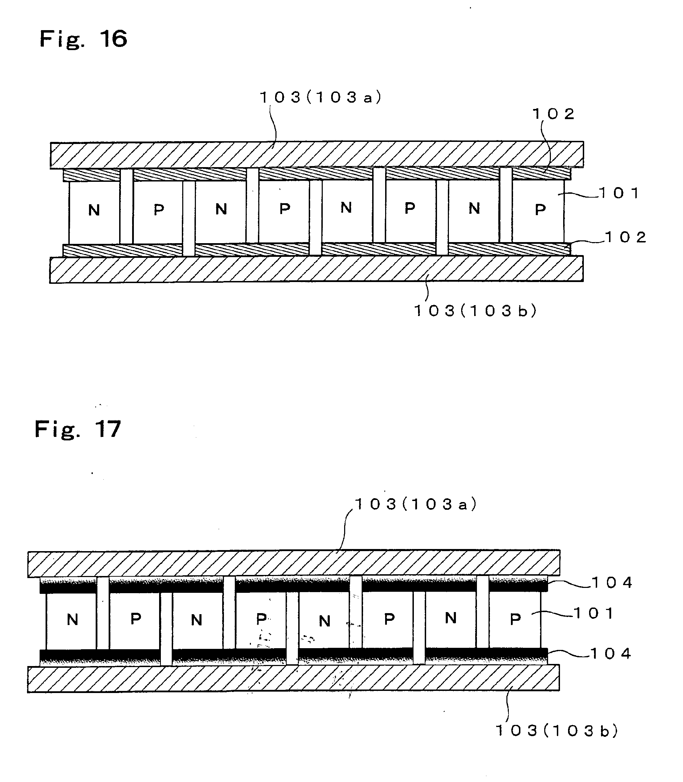

As shown in FIG. 16, a conventional thermoelectric conversion module has a general configuration in which an electrical circuit is configured by providing electrodes 102 on top and under surfaces of multiple pairs of thermoelectric semiconductors 101, and an electrical insulating plate 103 such as a ceramics plate or a metal plate having an electrical insulating film are further provided outside each electrode. The multiple pairs of thermoelectric semiconductors 101 and the electrodes 102 are joined by a jointing material such as an adhesive or a brazing filler metal and sandwiched by two plates 103 so as to assemble the thermoelectric conversion module. There is another form, as shown in FIG. 17, in which one or both of the electrodes 102 of the thermoelectric semiconductor 101 are replaced by compliant pads (FGM compliant pads, refer to Japanese Patents Nos. 3056047 and 3482094) 104 made of functionally graded materials having an electrode layer and an electrical insulating layer, and the plates 103 which are electrically insulating such as ceramics or conductive such as a metal are provided outside them.

Furthermore, the thermoelectric conversion module can have its electrical circuit configured by the thermoelectric semiconductors 101 and electrodes 102 or the FGM compliant pads 104 only, and so the plates 103 for sandwiching the thermoelectric semiconductors 101 are not indispensable in terms of power generation. Therefore, there are also the thermoelectric conversion modules of the configuration without the plates 103 on one side or both sides. Such a configuration having no plate 103 on one side or both sides is called a skeleton type because its inside is visible.

However, the thermoelectric conversion module of the skeleton type joins the thermoelectric semiconductors 101 mutually with the electrodes 102 or the compliant pads 104 only, and so it has a fault of being weak in strength and fragile. In particular, the skeleton configuration having no plate 103 on both sides is so difficult to assemble that it does not suit industrial mass production even though manual assembly is possible. For the above reason, the conventional thermoelectric conversion module on a mass production scale has the general configuration having the plates 103 on both sides as shown in FIGS. 16 and 17.

In reality, upsizing is difficult as to the configuration of the thermoelectric conversion module shown in FIGS. 16 and 17, where plane dimensions are 4-cm square in general and 7-cm square or so even in the case of a large one. Further upsizing is not possible because a thermal stress caused by a temperature difference with which the thermoelectric conversion module is loaded is approximately proportional to a product of the temperature difference and dimensions of the thermoelectric conversion module. Specifically, among the plates sandwiching the thermoelectric semiconductors, a plate 103a on the side of a heating plane placed on a high-temperature heat source side in particular expands thermally. Therefore, the electrodes 102 or FGM compliant pads 104 in a peripheral part of the plate 103a and the heating plane side of the thermoelectric semiconductors 101 joined therewith move in the same direction in conjunction with thermal expansion of the plate 103a. However, a plate 103b on the side of a cooling plane placed on a low-temperature heat source side does not expand thermally. Therefore, there is a possibility that a shearing stress acts on the thermoelectric semiconductors 101 and the electrodes 102 or FGM compliant pads 104 on top and bottom thereof so as to destroy the fragile thermoelectric semiconductors 101 and cause peel-off on a joint surface between members. This problem is especially serious for a high-temperature thermoelectric conversion module of 500°C or higher operating temperature on the assumption of automobiles and industrial waste heat. For instance, in the case of heating it up to 500°C when copper or stainless steel is adopted as the plate 103a on the heating plane side of a 4-cm square module, an amount of displacement of an end (a relative amount of displacement measured from center of the plate) is 0.16 mm or so. In the case where the plate 103a is the ceramics, the amount of displacement is 0.07 mm or so. Generation of the shearing stress due to the thermal expansion of the heating plate 103a becomes an unignorable problem in conjunction with the upsizing of the heating plate 103a, which becomes a factor blocking the upsizing of the module.

To increase output per unit area in a thermoelectric conversion system having multiple thermoelectric conversion modules, it is necessary to increase filling density of the thermoelectric semiconductors 101. In the case of a conventional thermoelectric conversion system, the filling density is 50% or so. There are the following reasons for being unable to further increase the filling density. (1) Proper clearances are required so as not to have the thermoelectric semiconductors 101 mutually in contact and shorted out. (2) There are places incapable of putting the thermoelectric semiconductors 101 around the thermoelectric conversion module and in a lead wire fixing portion. (3) A proper clearance is required between the thermoelectric conversion modules so as not to mutually interfere. Of the above, the smaller the thermoelectric conversion module is, the relatively more significant influence of (2) and (3) becomes. Therefore, to increase the filling density, it is desirable to upsize the thermoelectric conversion module as much as possible. In that case, however, another problem arises in conjunction with the upsizing as described above. It is also required to reduce thermal resistance for the sake of improving thermoelectric conversion efficiency. It is difficult, however, to reduce the thermal resistance because fragile thermoelectric semiconductors may be destroyed by pressure if strongly sandwiched between the heating plate and a cooling plate in order to put components of the thermoelectric conversion module in intimate contact.

In the case where an atmosphere in which the thermoelectric conversion module is installed is an oxidizing atmosphere such as midair at high temperature or a corrosive atmosphere such as a combustion gas of a garbage incinerator, there is a possibility of oxidization or corrosion as to the thermoelectric conversion module of the configuration exposing the thermoelectric semiconductors and electrode portions to the outside air. Therefore, the conventional thermoelectric conversion module cannot be installed barely in such an atmosphere, and so a general method is to isolate the high-temperature gas with a duct or a partition and indirectly heat the thermoelectric conversion module. However, such a system not only requires a configuration such as the duct or partition anew but also has a fault that power generation performance of the thermoelectric conversion module is reduced by a decrease in the temperature difference applied to the thermoelectric semiconductors due to indirect heating.

Thus, an object of the present invention is to provide the thermoelectric conversion module which has realized a large-size module with soundness and improved substantial filling density of the thermoelectric semiconductors and is able to increase power density. Another object of the present invention is to provide the thermoelectric conversion module capable of improving its strength and being used in any atmosphere.

SUMMARY OF THE INVENTION

To achieve these objects, a thermoelectric conversion module of the present invention includes at least a pair of thermoelectric semiconductors, a heat source side electrode portion installed on a plane of a high-temperature heat source side of the thermoelectric semiconductors for electrically connecting the thermoelectric semiconductors in series, a radiation side electrode portion installed on a plane of a low-temperature heat source side of the thermoelectric semiconductors for electrically connecting the thermoelectric semiconductors in series, a heating plate for covering the heat source side electrode portion and receiving heat from a high-temperature heat source, a cooling plate for covering the radiation side electrode portion and conveying the heat to a low-temperature heat source, a sliding member having high heat conductivity and intervening at least between the heat source side electrode portion and the heating plate, and a coupling plate for coupling the cooling plate to the heating plate and sandwiching the thermoelectric semiconductors and the electrode portions between the cooling plate and the heating plate via the sliding member so as to integrate them, wherein the sliding member is pressed onto the heat source side electrode portion and held integrally therewith by a pressurizing force working between the heating plate and the cooling plate, and the sliding member in the pressurized state allows relative sliding between the sliding member and the heat source side electrode portion or the heating plate.

Therefore, according to the present invention, even if the heating plate on the high-temperature heat source side expands thermally, sliding occurs between the heating plate and a sheet member, and so no shearing stress acts on the thermoelectric semiconductors, heat source side electrode portion and radiation side electrode portion. Thus, even if the thermoelectric conversion module is upsized, it neither destroys fragile thermoelectric semiconductors nor causes peel-off on a joint surface. For this reason, it is possible to upsize the thermoelectric conversion module, improve substantial filling density of the thermoelectric semiconductors and increase power density (output per unit area). Interfaces having the sheet member intervening are put in intimate contact well by the pressurizing force working on the thermoelectric conversion module so as to reduce thermal contact resistance on the interfaces. It is thereby possible to load the thermoelectric semiconductors with a large temperature difference. Furthermore, the thermoelectric conversion module of the present invention has the cooling plate and the heating plate coupled by the coupling plate and is integrated between the cooling plate and the heating plate by sandwiching the thermoelectric semiconductors and electrode portions via the sliding member. Therefore, it has high strength as a module and is hardly destructible, easy to handle and besides, easy to assemble and suited to industrial mass production.

As for the thermoelectric conversion module of the present invention, it is desirable that the heating plate and the cooling plate have all their surrounding side faces covered by the coupling plate to configure an airtight container for sealing a space between the heating plate and the cooling plate, and a pressure in the container be rendered lower than the pressure outside the container so as to have a pressurizing force exerted between the heating plate and the cooling plate by a differential pressure. In the case of thus placing the coupling plate on all their surrounding side faces to configure the airtight container, components of the thermoelectric conversion module are sealed in the container, and so it is usable in any atmosphere, such as an oxidizing atmosphere or a corrosive atmosphere. In addition, the components of the thermoelectric conversion module are accommodated in the container so that the strength against an external force is enhanced. Furthermore, the interfaces having the sheet member intervening are pressurized from outside the container by the differential pressure between the inside and outside of the container so as to reduce the thermal contact resistance on the interfaces due to good adhesiveness. It is thereby possible to load the thermoelectric semiconductors with a large temperature difference.

In the case of sealing the components of the thermoelectric conversion module by using the airtight container, it is desirable to render the inside of the container as a vacuum, an inert atmosphere or a reducing atmosphere. In this case, it is possible to prevent deterioration caused by oxidization of the components and sliding member of the thermoelectric conversion module accommodated in the container.

Here, the sliding member is at least heat-conductive and slidable. The sliding member should desirably be electrically insulating. However, if an electrical insulating member or an electrical insulating layer intervenes between the electrode portion and the sliding member, the sliding member itself does not need to be electrically insulating. Thus, it is desirable, as for the sliding member, to use a heat-conductive sheet member of a low friction coefficient or a viscous substance such as grease. Furthermore, it is desirable to use a carbon sheet or a polymer sheet as the sheet member. The carbon sheet is excellent enough in slidableness, heat conduction and heat resistance to allow use of the thermoelectric semiconductors of higher maximum operating temperature and reduce the thermal resistance of the interface having the carbon sheet intervening to 1/10 or less of the case of having no carbon sheet. In particular, when accommodating it in the airtight container and using it, it is usable up to a higher temperature than the case of using it in the atmosphere. As the polymer sheet is excellent in slidableness and also electrically insulating, it can be in direct contact with either an electrode member having no electrical insulating layer or an FGM compliant pad having the electrical insulating layer.

Furthermore, in the case of using the carbon sheet as the sliding member, the electrode portion contacting the sliding member should desirably be configured by functionally graded materials having the electrode layer and electrical insulating layer. It is further desirable to have a mica sheet intervening between the heat source side electrode portion and the carbon sheet. In this case, it is possible to ensure electrical insulation between the carbon sheet and the electrode portion and then render the sliding between the heating plate and the electrode portion good.

In the case of using heat-conductive grease as the sliding member, the container should desirably be the airtight container. In this case, the heat-conductive grease between a heating side inner surface of the container and the heat source side electrode portion allows relative slide movement of the container and the heat source side electrode portion and thereby prevents occurrence of the shearing stress. As the grease is the viscous substance, it puts the heating plate and the electrode portion in intimate contact without clearance so as to reduce the thermal contact resistance on the interfaces. It is thereby possible to load the thermoelectric semiconductors with a large temperature difference. Furthermore, as it is sealed in the airtight container, there are no longer problems of deterioration of the grease due to thermal oxidation and evaporation of the grease. It is thus possible to hold the grease stably between the container and the heat source side electrode portion for a long period of time.

It is desirable that the container of the thermoelectric conversion module according to the present invention have a bellows capable of expanding and contracting an interval between the heating plate and the cooling plate in the coupling plate portion, and the bellows be deformed by the pressurizing force working between the heating plate and the cooling plate so as to put the heating plate and the heat source side electrode portion in intimate contact via the sliding member. In this case, the bellows is deformed by the pressure exerted by the differential pressure between the inside and outside of the container so as to promote the intimate contact between the heating side inner surface of the container and the components of the thermoelectric conversion module inside the container.

It is desirable that the thermoelectric conversion module of the present invention have an emissivity of the surface of the coupling plate smaller than the emissivity of the surface of the heating plate facing the high-temperature heat source. In this case, the surface of the heating plate of a high emissivity facing the high-temperature heat source becomes more heat-absorbing and heated while the surface of the coupling plate surrounding the thermoelectric semiconductors has a low emissivity and becomes less heat-absorbing and less heated. Therefore, it is possible to increase the temperature difference which the thermoelectric semiconductors is loaded with by blocking heat input from around the thermoelectric semiconductors. Power generation performance of the thermoelectric conversion module is proportional to approximately a square of the temperature difference which the thermoelectric semiconductors is loaded with. Therefore, it is possible to improve the power generation performance of the thermoelectric conversion module significantly by setting different emissivities on the heating plate as a heat receiving surface and the coupling plate as the side face. Furthermore, a heat input amount not contributing to the power generation from the side face of the thermoelectric conversion module, that is, the coupling plate portion becomes smaller. Therefore, in the case of using the airtight container, it suppresses increase in internal pressure and does not block the intimate contact among the parts due to expansion of the container, and is also able to reduce a degree of pressure reduction in the container itself.

It is also desirable that the thermoelectric conversion module of the present invention have a heat transfer cushion having a low melting point material showing a liquid state at the operating temperature of the thermoelectric conversion module and a shell with flexibility for including the low melting point material and allowing deformation of low melting point material in the liquid state at least either between the heating plate and the high-temperature heat source contacting the heating plate or between the cooling plate and the low-temperature heat source contacting the cooling plate. Thus, the low melting point material showing the liquid state at the operating temperature and the flexible shell for including the low melting point material follow curved surface deformation (out-of-plane deformation) of a heat transfer surface in contact and fill the two heat transfer surfaces well so as to prevent a gap from being made between the two surfaces. Therefore, the heat transfer cushion is constantly in good intimate contact with the opposed two surfaces. Furthermore, the low melting point material in the liquid state has such high heat conductivity that it can keep thermal resistance of the heat transfer cushion low and transfer the heat efficiently. It is thereby possible, compared to the conventional cases, to increase the temperature difference for loading the thermoelectric conversion module with and improve generated output of the thermoelectric conversion module. To be more specific, it is possible to improve substantial energy conversion efficiency. It is thereby possible to reduce a power generation unit price of a thermoelectric conversion system. And the flexible shell including the low melting point material in the liquid state functions as the cushion so that the high-temperature heat source and the heating plate can be in intimate contact without forcibly sandwiching them. Therefore, it is possible to prevent the thermoelectric semiconductors from being destroyed by the pressurizing force working on the thermoelectric conversion module.

Furthermore, it is desirable to have a second sliding member made of the heat-conductive sheet member of a low friction coefficient intervening between the heat transfer cushion and the heating plate or the cooling plate. In this case, if the heat transfer surface thermally expands, the heat transfer surface is slid on a second sheet member to move slidingly in a plane direction so as to release the shearing stress acting on the shell and prevent destruction of the shell. It is thereby possible to accept a large thermal expansion displacement due to the temperature difference during operation and stop of a large-size heating. duct for instance when the heat transfer surface is large.

BRIEF DESCRIPTION OF THE DRAWINGS

FIG. 1 is a longitudinal section showing an embodiment of a thermoelectric conversion module according to the present invention;
FIG. 2 is a longitudinal section showing another embodiment of the thermoelectric conversion module;
FIG. 3 is a longitudinal section showing a further embodiment of the thermoelectric conversion module;
FIG. 4 is a longitudinal section showing a still further embodiment of the thermoelectric conversion module;
FIG. 5 is a longitudinal section showing a configuration example of the thermoelectric conversion module using grease instead of a sheet member;
FIG. 6 is a longitudinal section showing a configuration example of the thermoelectric conversion module having a nozzle portion for setting an internal pressure of a container as a target value provided thereon.
FIG. 7 is a plan view of the thermoelectric conversion module of FIG. 1;
FIG. 8 is a longitudinal section showing another configuration example of the container;
FIG. 9 is a longitudinal section showing a further configuration example of the container;
FIG. 10 is a longitudinal section showing a configuration example of the thermoelectric conversion module having a bellows provided thereon;
FIG. 11 is a longitudinal section showing a configuration example of the thermoelectric conversion module having a heat transfer cushion provided thereon;
FIG. 12 is a longitudinal section showing a configuration example of the thermoelectric conversion module having different emissivities;
FIG. 13 is a longitudinal section showing an example of another embodiment of the thermoelectric conversion module according to the present invention;
FIG. 14 is a longitudinal section showing an embodiment of the thermoelectric conversion module using a non-airtight container;
FIG. 15 is a perspective view showing an embodiment of the thermoelectric conversion module using an airtight container, showing its internal configuration by sectionalizing it;
FIG. 16 is a longitudinal section showing a conventional thermoelectric conversion module; and
FIG. 17 is a longitudinal section showing another configuration of the conventional thermoelectric conversion module.

DETAILED DESCRIPTION OF THE PREFERRED EMBODIMENTS

Hereunder, configurations of the present invention will be described in detail based on embodiments shown in the drawings.

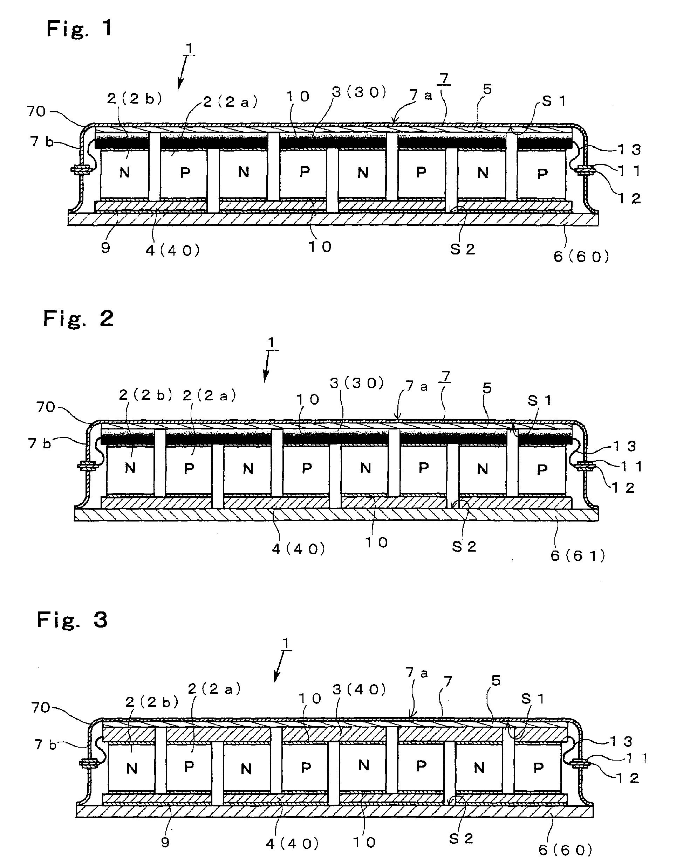

FIGS. 1 to 9 show an embodiment of a thermoelectric conversion module according to the present invention. This thermoelectric conversion module 1 is a type for sealing thermoelectric semiconductors 2 in an airtight container 7, and includes at least a pair of thermoelectric semiconductors 2, a heat source side electrode portion 3 installed on a plane of a heat source side of the thermoelectric semiconductors 2 and electrically connected to the thermoelectric semiconductors 2, a radiation side electrode portion 4 installed on a plane of a low-temperature side of the thermoelectric semiconductors 2 on the opposite side to the heat source side electrode portion 3 and electrically connected to the thermoelectric semiconductors 2, a heating plate 7a and a cooling plate 6 for configuring a heat receiving portion by covering the electrode portions 3 and 4 respectively, wherein power is generated by a temperature difference applied between a heat receiving plane of a high temperature side and a radiation plane of the low-temperature side of the thermoelectric semiconductors 2 via the heating plate 7a and cooling plate 6 respectively.

This thermoelectric conversion system 1 has a sliding member 5 having high heat conductivity provided at least between the heating plate 7a and the heat source side electrode portion 3, where the heating plate 7a and the heat source side electrode portion 3 are thermally coupled by having the sliding member 5 intervening between them. Here, the sliding member 5 should be a substance at least having high heat conductivity and facilitating sliding between the two members, for which a heat-conductive sheet member made of a material of a low friction coefficient or heat-conductive grease is adopted in this embodiment. The heating plate 7a and cooling plate 6 of this embodiment configure a part of the airtight container 7 for accommodating the thermoelectric semiconductors 2 and electrode portions 3 and 4. To be more specific, the heating plate 7a and cooling plate 6 are coupled to have all their surrounding side faces covered by a coupling plate 7b so as to configure the airtight container 7 for sealing a space between the heating plate 7a and the cooling plate 6. And a pressure in the container 7 is rendered lower than the pressure outside the container 7 so that the sliding member 5 is pressed onto the heat source side electrode portion 3 to be in intimate contact and held integrally therewith by a pressurizing force due to a differential pressure between the inside and the outside of the container working between the heating plate 7a and the cooling plate 6, that is, an inner surface of the heating plate 7a (referred to as a high temperature surface S1) and an inner surface of the cooling plate 6 (referred to as a low temperature surface S2). The heat source is not shown in the examples in FIGS. 1 to 9. As for the thermoelectric conversion module of this embodiment, a method of heat receiving is not especially limited, which may be either heat transfer by direct contact with the heat source to the heating plate of a container top or heat transfer by radiation heat from a distant heat source or a gaseous heat source.

The airtight container 7 in this embodiment is configured by the cooling plate 6 of high rigidity and a lid 70 in a relatively flexible box form for covering the cooling plate 6, which are integrated by joining the cooling plate 6 to periphery of the lid 70 by means of welding, an adhesive or brazing. The lid 70 includes the heating plate 7a and coupling plate 7b portions, and is made by press-forming one thin metal sheet for instance. Here, a top face 7a opposed to a sheet member 5 of the lid 70 is equivalent to the heating plate, and a peripheral side faces 7b are equivalent to the coupling plate.

The container 7 is pressed from the outside because of the differential pressure between the inside and the outside. This pressing force is used to evenly press the sheet member 5 and the heat source side electrode portion 3 located further inside with the inner surface of the heating plate 7a of the container 7. The container 7 is flexible enough to be deformed by the differential pressure between the inside and the outside and press the sheet member 5 well, and is also rigid enough to secure sealability even if pressed by the outside air.

In the case of configuring a low-temperature thermoelectric conversion module 1 by using BiTe as the thermoelectric semiconductors 2 for instance, the temperature of the heating plate 7a of the top face of the container 7 is 250°C or less for instance. Therefore, aluminum (Al), copper (Cu) or stainless steel (JIS SUS304 or SUS316 for instance) may be adopted as the material of the lid 70. In the case of configuring a high-temperature thermoelectric conversion module 1 by using FeSi as the thermoelectric semiconductors 2 for instance, the temperature of the heating side, that is, the heating plate 7a portion of the container 7 is 600°C or so for instance. Therefore, INCONEL (Special Metals Corporation trademark) may be adopted as the material of the lid 70.

However, the material of the lid 70 is neither limited to those exemplified above nor limited to metals. It may be selected as appropriate from a viewpoint of heat resistance, corrosion resistance and workability. Press forming is not limited to manufacturing of the lid 70 as an integral product. For instance, in the case of the material whereby it is difficult to perform deep drawing on one sheet by press forming, it is feasible to press-form only the heating plate 7a portion of the top face opposed to the sheet member 5 and a curvature portion (part of the coupling plate) around it with one sheet, and prepare other side face portions, that is, the remaining coupling plate portion integrally with the cooling plate or with another member (metal or ceramic) to assemble them by a method using welding, brazing or the adhesive so as to configure the container 7.

It is desirable to render thickness of the lid 70 configuring the heating plate 7a portion and the coupling plate 7b portion slim for the sake of being deformed by the differential pressure between the inside and the outside to press the sheet member 5 well and reducing the thermal resistance. For instance, it should desirably be 20 $\mu$m to 0.5 mm or so. However, it is not limited to the examples, but should be decided as appropriate according to size of the thermoelectric conversion module 1, quantity of the differential pressure and so on.

As for the sheet member 5 for intervening between the inner surface of the heating plate 7a (high temperature surface S1) and the heat source side electrode portion 3, a selected material should be capable of reducing thermal contact resistance, having high slidableness (that is, a low friction coefficient), heat resistance and flexibility capable of following the deformation of the heating plate 7a portion of the container 7. It is more desirable to select the material having high heat conductivity in the direction of thickness. For instance, it is desirable to use a carbon sheet or a polymer sheet.

As the carbon sheet is electrically conductive, the heat source side electrode portion 3 needs to have an insulating layer in the case of using the carbon sheet as the sheet member 5. In the case of using an electrical insulating sheet such as the polymer sheet as the sheet member 5, the heat source side electrode portion 3 needs to have no insulating layer. It is also possible to use a compliant pad (FGM compliant pad) 30 made of functionally graded materials having an electrode layer and an electrical insulating layer as the heat source side electrode portion 3 having the insulating layer. The FGM compliant pad 30 has the electrode layer on the thermoelectric semiconductors 2 side and the electrical insulating layer on the opposite side, where composition thereof continuously changes. For instance, the ones disclosed in Japanese Patents Nos. 3056047 and 3482094 may be used. It is also possible to use the FGM compliant pad 30 of which both sides consist of the electrode layers and inside consists of the electrical insulating layer.

Here, the existing carbon sheet generally has high heat conductivity in the plane direction and a low heat conductivity in the direction of thickness. However, it became evident, as a result of an experiment by the inventors hereof, that even such an existing carbon sheet can have an effect of significantly reducing the thermal contact resistance. The following will describe the experiment.

The carbon sheet 0.15-mm thick and having the heat conductivity of is 5W/mK in the direction of thickness, for instance, intervenes between two copper blocks, and was pressurized at 0.4 kg/cm$^2$ to measure the thermal resistance. As a comparative example, the thermal resistance was measured by applying the same pressure to the two blocks via no carbon sheet. Furthermore, the measurement was performed by changing temperature conditions. Results of the measurement are shown in Table 1.

[Table 1]

| Temperature (°C) | 150 | 200 | 300 | 400 |
|---|---|---|---|---|
| Total thermal resistance when using the carbon sheet $\times 10^{-5}$ (m$^2$K/W) | 10 | 10 | 9 | 9 |
| Thermal contact resistance when using no carbon sheet $\times 10^{-5}$ (m$^2$K/W) | 140 | 120 | 100 | 100 |

The values of the thermal resistance when using the carbon sheet shown in Table 1 hardly change if the two copper blocks sandwiching the carbon sheet are relatively displaced in parallel with the surface of the carbon sheet. The thermal resistance when using the carbon sheet shown in Table 1 is a total of the thermal contact resistance with the copper blocks on top and bottom of the carbon sheet and the thermal resistance of the carbon sheet itself. The thermal resistance Rc of the carbon sheet itself thereof can be acquired by calculation of formula 1.

$$\text{Thermal resistance Rc of the carbon sheet itself} = (\text{thickness})/(\text{heat conductivity})$$

$$= 0.15 \times 10^{-3} \text{ (m)}/5 \text{ (W/mK)}$$

$$= 3 \times 10^{-5} \text{ (m}^2\text{K/W)} \quad ... (1)$$

If the total of the thermal resistance is R, the thermal contact resistance with the copper blocks on top and bottom of the carbon sheet is calculated by (R - Rc)/2. To be more specific, the thermal contact resistance with the copper blocks on top and bottom of the carbon sheet is presumably 3.5 x 10$^{-5}$ m$^2$K/W at 150 to 200°C, and 3 x 10$^{-5}$ m$^2$K/W at 300 to 400°C.

The thermal contact resistance of the two copper blocks in the case of having no carbon sheet intervening is 100 x 10$^{-5}$ m$^2$K/W or more. Thus, the thermal resistance can be reduced to 1/10 or less by adopting the carbon sheet. From the above experiment results, it is desirable to have the pressurizing force of 0.4 kg/cm$^2$ or more working on the carbon sheet in order to exert an effect of having the thermal contact resistance reduced by the carbon sheet. The carbon sheet having its heat conductivity enhanced in the direction of thickness is under development. It is possible, by adopting such a carbon sheet, to further reduce the thermal resistance.

The carbon sheet is generally usable up to 400°C or so in the atmosphere and up to 1,100°C or so in a vacuum or an inert atmosphere. Therefore, the carbon sheet itself is usable up to 1,100°C by rendering the inside of the container 7 as the vacuum or inert atmosphere. The maximum operating temperature of the thermoelectric conversion module 1 is generally decided by constraints of the thermoelectric semiconductors 2. Even in the case of SiGe usable at the highest temperature, however, the maximum operating temperature is 1,100°C. Therefore, it is possible to support any thermoelectric semiconductor 2 by using the carbon sheet and rendering the inside of the container 7 as the vacuum or inert atmosphere.

The inside of the container 7 should be either the vacuum or a negative pressure as the pressure of the atmosphere for installing the container 7 so as to put the inner surface of the heating side (high temperature surface S1) of the container 7 and the heat source side electrode portion 3 in intimate contact via the sheet member 5. It may be decided as appropriate as to whether the inside of the container 7 should be the vacuum or a reduced-pressure atmosphere based on the pressure of an installation atmosphere and operating temperature. In the case of rendering the inside of the container 7 as the reduced-pressure atmosphere, the inside of the container 7 may also be rendered as the inert atmosphere or a reducing atmosphere. It is thereby possible to prevent deterioration caused by oxidization of the components of the thermoelectric conversion module 1 accommodated inside the container 7. As for an inert gas, argon (Ar) is optimal. While other inert gases are also usable, nitrogen (N) requires caution because some materials thereof react at high temperature, and helium (He) is not so suitable because it is leaky. There are also material systems suited to charging hydrogen ($H_2$) and rendering it as the reducing atmosphere.

For instance, if a charged pressure ($P_{RT}$) at a room temperature (27°C) is -0.8 atmospheres (gage pressure) on the thermoelectric conversion module 1 operated at 550°C under atmospheric pressure, internal pressure $P_{550}$ on heating it up to 550°C is calculated by formula 2 according to the Boyle-Charles' law.

$$P_{550} = 0.2 \times (550 + 273)/(27 + 273)$$

$$= 0.55 \text{ atmospheres (absolute pressure)}$$

$$= -0.45 \text{ atmospheres (gage pressure)} \qquad \ldots (2)$$

Therefore, it is possible to maintain the negative pressure even at 550°C. The pressure for pressing the container 7 from outside in this case is 0.45 kg/cm$^2$ = 4.5 ton/m$^2$. As shown in Table 1, it is effective, for the sake of reducing the thermal contact resistance, to apply pressure at 0.4 kg/cm$^2$ by having the carbon sheet intervening. Thus, the above-mentioned effect of the carbon sheet can be expected.

Table 2 shows a relation between the charged pressure at the room temperature (27°C) and the differential pressure at 550°C. The atmosphere (external pressure) for installing the thermoelectric conversion module 1 was calculated as the atmospheric pressure. The unit of pressure shown in Table 2 is normal atmosphere.

[Table 2]

| Cases for consideration | 1 | 2 | 3 | 4 |
|---|---|---|---|---|
| at a room temperature (27°C) <br> Charged pressure (gage pressure) <br> Charged pressure (absolute pressure):$P_{RT}$ | -1 <br> 0 | -0.8 <br> 0.2 | -0.7 <br> 0.3 | -0.6 <br> 0.4 |
| Internal pressure at 550 °C (absolute pressure) : $P_{550}$ | 0 | 0.55 | 0.82 | 1.1 |
| External pressure (absolute pressure): Pout | 1.0 | 1.0 | 1.0 | 1.0 |
| Differential pressure: Pout -$P_{550}$ | 1.0 | 0.45 | 0.18 | -0.1 |
| Determination | Good | Good | No good | No good |

An instance 1 is the case where the inside of the container 7 is a vacuum, and it has a sufficient effect to receive the differential pressure of 1 atmosphere. An instance 2 is the above-mentioned case where the charged pressure ($P_{RT}$) at the room temperature (27°C) is -0.8 atmospheres (gage pressure), and it also has a sufficient effect. An instance 3 is the case where the differential pressure is insufficient, and there is a possibility that the thermal contact resistance of that point may increase a little. An instance 4 is the case where the internal pressure of the container 7 is larger than the external pressure and the container 7 expands, and so the inner surface of the heating side (high temperature surface S1) of the container 7 and the heat source side electrode portion 3 cannot be in intimate contact via the sheet member 5, resulting in extreme increase in the thermal contact resistance. In view of the above, the instances 1 and 2 of Table 2 are desirable to achieve the differential pressure of 0.4 atmospheres or more, and the instances 3 and 4 should be avoided.

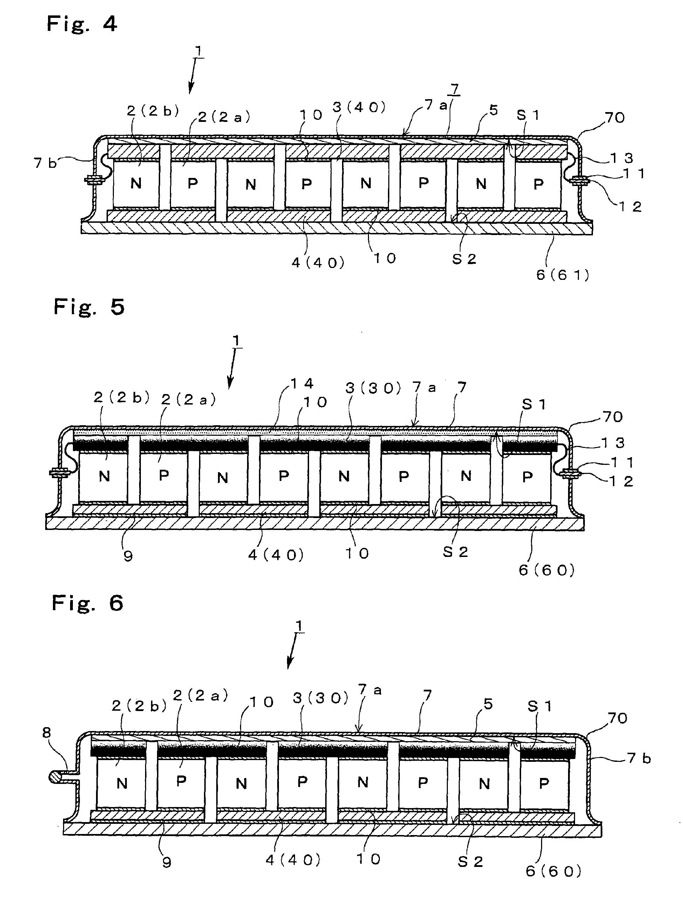

The method of setting the internal pressure of the container 7 at a target value will be exemplified hereunder. In the case of electron-beam-welding the lid 70 and cooling plate 6 configuring the container 7, it is performed in a vacuum atmosphere and so the inside of the container 7 can be vacuumized by adopting the above welding method. As for the method of setting the internal pressure of the container 7 at a target value without vacuumizing the inside of the container 7, a nozzle portion 8 is provided on the side face of the container 7 as shown in FIG. 6 for instance. And the lid 70 and the cooling plate 6 are joined by welding or brazing, and the integrated lid 70 and cooling plate 6 are put in a glove box not shown and are vacuumed first, and then the inert gas or reducing gas is introduced into the glove box to reach a target pressure. Thus, the inside of the container 7 will have the same pressure. Thereafter, the end of the nozzle portion 8 is crushed with a tool and the container 7 is temporarily sealed. Furthermore, the container 7 is taken out of the glove box, and the end of the nozzle portion 8 is completely sealed by welding or brazing.

FIGS. 1 to 9 show configuration examples of the thermoelectric conversion module 1.

For instance, the thermoelectric conversion module 1 shown in FIG. 1 includes P-type thermoelectric semiconductors 2a and N-type thermoelectric semiconductors 2b as the thermoelectric semiconductors 2 alternately arranged, the FGM compliant pads 30 as the heat source side electrode portions 3 for electrically coupling adjacent P-type thermoelectric semiconductors 2a and N-type thermoelectric semiconductors 2b in series on the heat source side, electrode members 40 as the radiation side electrode portions 4 for electrically coupling adjacent P-type thermoelectric semiconductors 2a and N-type thermoelectric semiconductors 2b in series on the cooling plate 6 side, the carbon sheet as the sheet member 5 placed on the surfaces of the FGM compliant pads 30, the cooling plate 6 on which the electrode members 40 are mounted, and the lid 70 having its periphery joined with the cooling plate 6 and configuring the airtight container 7, wherein the sheet member 5 intervenes between the heating plate 7a portion of the top face of the lid 70 and the cooling plate 6 so as to integrate and accommodate the thermoelectric semiconductors 2 and the electrode portions 3 and 4 by sandwiching them.

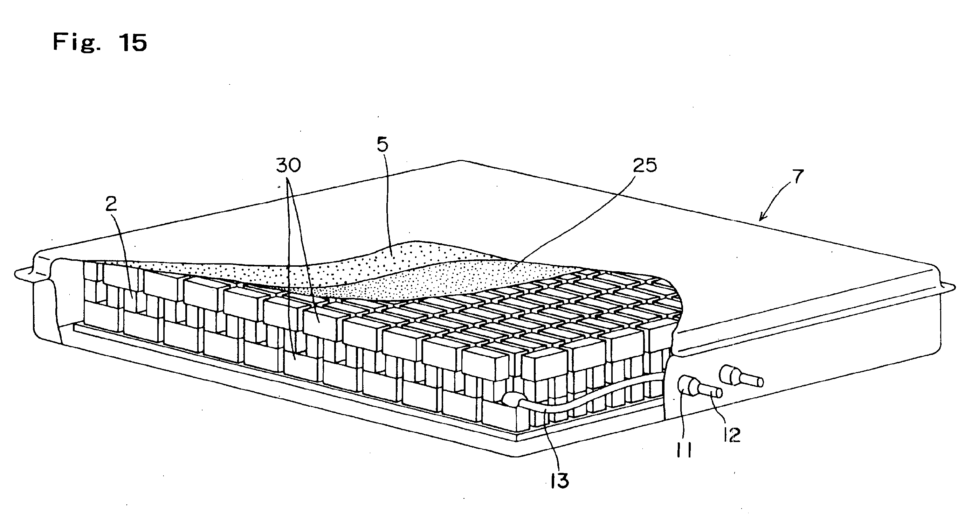

The cooling plate 6 is a metal plate 60 for instance, and the electrode members 40 which are electrically conductive are joined to the metal plate 60 by an electrical insulating jointing member 9. The P-type thermoelectric semiconductors 2a and N-type thermoelectric semiconductors 2b as the thermoelectric semiconductors 2 are joined to the FGM compliant pads 30 and the electrode members 40 by a conductive jointing member 10. As the FGM compliant pad 30 has the electrical insulating layer therein, it can be in direct contact with an electrically conductive carbon sheet 5 as the sheet member 5. If the FGM compliant pad 30 is joined on the metal cooling plate 60, the electrode member 40 which is electrically conductive does not need to be placed by the electrical insulating jointing member 9. Thus, in the case of using the carbon sheet of excellent heat resistance in the airtight container 7 as the sliding member 5, it is possible to use FeSi (maximum operating temperature is 700°C or so) and SiGe (maximum operating temperature is 1,000°C or so) as the thermoelectric semiconductors. Furthermore, it is desirable, as shown in FIG. 15, to have the electrical insulating sheet member such as a mica sheet 25 intervening between the carbon sheet 5 and the FGM compliant pads 30 so as to have sufficient electrical insulation. Here, if the sliding member 5 intervening between the heat source side electrode 3 and the heating plate 7a is the material combining all of the heat conductivity, electrical insulation and slidableness (sliding) such as the polymer sheet, it is not necessary to have the above-mentioned multiple layers. The lid 70 and the metal cooling plate 60 are put in intimate contact by means of welding for instance.

The thermoelectric conversion module 1 shown in FIG. 2 adopts a ceramic cooling plate 61 on which the electrode member 40 is evaporated or joined instead of the metal cooling plate 60 and the electrode member 40 joined thereto in FIG. 1. As the cooling plate 6 is configured by using the electrical insulating ceramic cooling plate 61, the electrical insulating jointing member 9 is not necessary between the cooling plate 6 and the electrode member 40. For instance, a product having copper evaporated in an electrode form on a plate of alumina is available as DBC (Direct Bonding Copper), which can be used as the cooling plate 6 and the electrode member 40. The lid 70 and the ceramic cooling plate 61 are put in intimate contact by using the adhesive or brazing filler metal for instance.

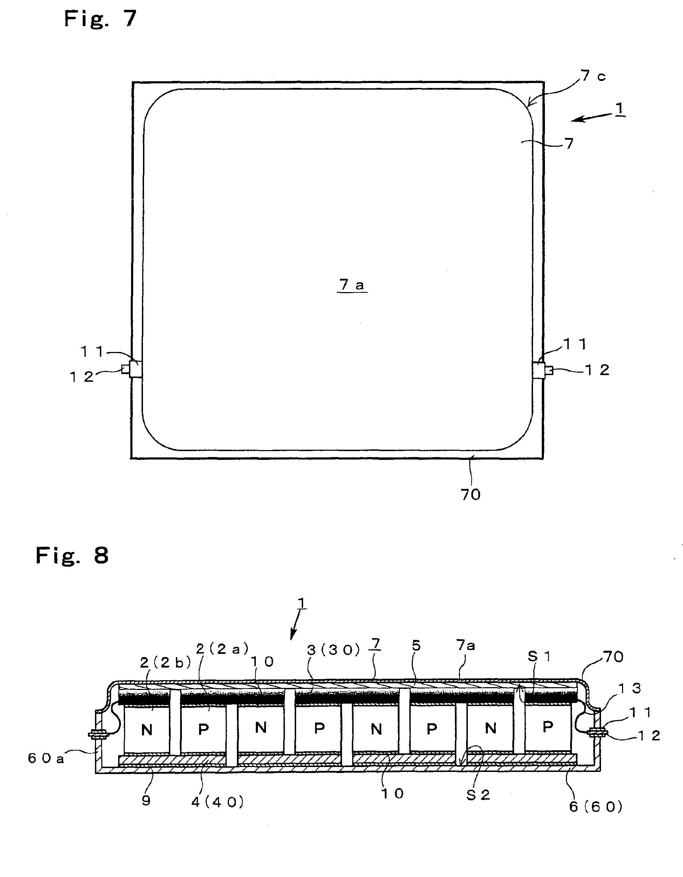

The thermoelectric conversion module 1 shown in FIG. 3 adopts the electrically conductive electrode member 40 which is the same as the radiation side electrode portion 4 as the heat source side electrode portion 3 instead of the FGM compliant pad 30 in FIG. 1. The sheet member 5 is not the carbon sheet but the polymer sheet. The polymer sheet is electrically insulating, and it can be in direct contact with either the electrode member 40 having no electrical insulating layer or the FGM compliant pad 30 having the electrical insulating layer. As for the polymer, it is desirable to use so-called quasi-super engineering plastics such as polyarylate, polysulfan, polyetherimide, and polyphenylenesulfide, or so-called super engineering plastics such as PEEK, polyamideimide, wholly aromatic ester and polyimide. In the case of these plastics, service temperature limits are 200 to 250°C or so. Therefore, it is possible to configure the low-temperature thermoelectric conversion module 1 by using BiTe as the thermoelectric semiconductors 2 for instance. The thermoelectric conversion module 1 shown in FIG. 4 adopts the electrode member 40 which is the same as the radiation side electrode portion 4 as the heat source side electrode portion 3 instead of the FGM compliant pad 30 in FIG. 2. The sheet member 5 is not the carbon sheet but the polymer sheet. The thermoelectric conversion module 1 shown in FIG. 6 is an example of providing the nozzle portion 8 for setting the internal pressure of the container 7 at the target value on the container 7 of the thermoelectric conversion module 1 of FIG. 1. FIG. 7 shows an example of a planar shape of the thermoelectric conversion module 1. To press-form the lid 70 out of one sheet of plate, it is desirable to add a curvature to an angle 7c as shown in FIG. 7 from a viewpoint of formability.

Here, the container 7 has a pair of conductive portions 12 penetrating its side face portion 7b via an electrical insulator 11. The ends of the conductive portions 12 inside the container 7 are connected to the heat source side electrode portion 3 of the thermoelectric conversion module 1 via a lead wire 13 for instance. According to this embodiment, this configuration allows the power generated by the thermoelectric conversion module 1 to be taken outside the container 7 while keeping the sealability of the container 7. The power generated by the thermoelectric conversion module 1 is supplied to an electrical storage device or power-utilizing apparatuses via a power collection line not shown.

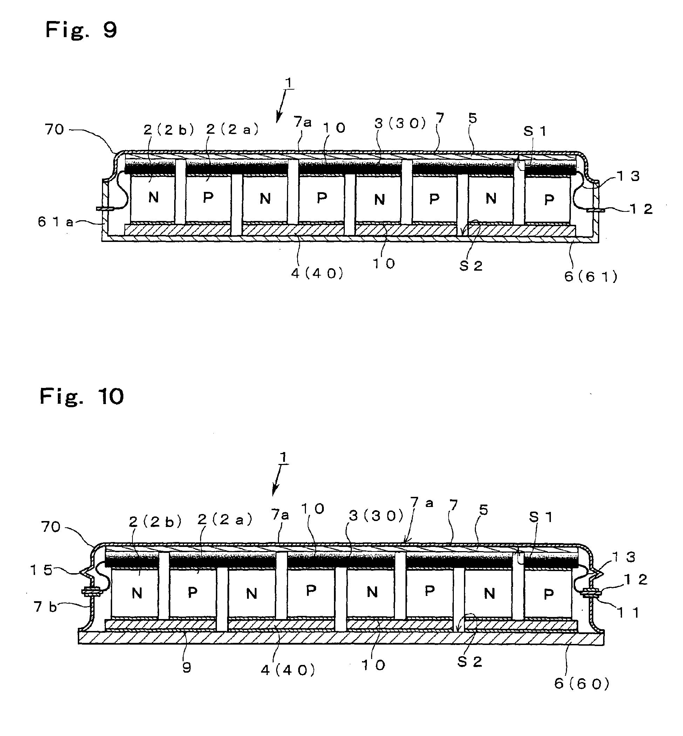

FIGS. 8 and 9 show other configuration examples of the container 7. FIG. 8 shows an example in which the periphery of the metal cooling plate 60 of FIG. 1 are erected toward the heat source side and the pair of conductive portions 12 is provided to the erected portion 60a of the metal cooling plate 60 via the electrical insulator 11. FIG. 9 shows an example in which the periphery of the ceramic cooling plate 61 of FIG. 2 are erected toward the heat source side and the pair of conductive portions 12 is provided to the erected portion 61a. In the configuration of FIG. 9, the ceramic cooling plate 61 is electrically insulating so that the conductive portions 12 can be directly mounted on the cooling plate 6 via no electrical insulator 11.

The thermoelectric conversion module 1 shown in FIG. 5 is an example of using a heat-conductive grease 14 instead of the sheet member 5 of FIG. 1. The grease 14 allows smooth slide movement between the inner surface of the heating plate 7a (high temperature surface S1) of the container 7 and the heat source side electrode portion 3. As for the grease 14 for intervening between the inner surface of the heating plate 7a portion of the container 7 and the heat source side electrode portion 3, it is desirable, for instance, to use the silicone oil grease 14 of which allowable temperature limit is 300°C or so. In particular, it is desirable to use a grease-like product having the silicone oil mixed with heat-conductive powder such as alumina. It is possible, by sealing the container 7 or rendering the inside of the container 7 as the vacuum or inert atmosphere, to eliminate the problems such as deterioration of the grease 14 due to thermal oxidation and evaporation of the grease 14 so as to hold the grease 14 stably between the heating plate 7a portion of the container 7 and the heat source side electrode portion 3 for a long period of time. As the grease 14 gets into intimate contact with the heating plate 7a portion of the container 7 and the heat source side electrode portion 3 well, the thermal contact resistance can be reduced.

It is possible for instance, by calculation of formula 3, to acquire a thermal resistance Rg of the grease 14 itself of which thickness is 0.04 mm and heat conductivity is 0.8 W/mK in the direction of thickness.

$$\text{Thermal resistance (Rg) of the grease itself} = (\text{thickness})/(\text{heat conductivity})$$

$$= 0.04 \times 10^{-3} \ (\text{m})/0.8 \ (\text{W/mK})$$

$$= 5 \times 10^{-5} \ (\text{m}^2\text{K/W}) \quad ... \ (3)$$

Therefore, it is expected that, on totaling the thermal contact resistance of the interface on which the grease 14 intervenes and the above Rg, the total of the thermal resistance will be the same value as the value on using the above-mentioned carbon sheet. In the case of using BiTe as the thermoelectric semiconductors 2, the maximum operating temperature is 220°C or so and so the silicone oil grease 14 exemplified above can be used.

The configuration examples of the thermoelectric conversion module 1 indicated above are the cases in point, and they are not limited to these exemplifications. For instance, it is also feasible to use the FGM compliant pad 30 instead of the electrode member 40 as the radiation side electrode portion 4. It is also feasible to render the thermoelectric conversion module 1 as a module having a minimum unit of the thermoelectric semiconductors 2, such as a uni-couple type having one each of the P-type and N-type thermoelectric semiconductors. In the case where it is possible to constantly maintain the state in which the thermoelectric conversion module 1 is integrally held by the pressurizing force due to the differential pressure between the inside and the outside of the container 7, it is not always necessary to provide the jointing members for connecting the heat source side electrode portion 3 or the radiation side electrode portion 4 to the thermoelectric semiconductors 2, and the radiation side electrode portion 4 to the cooling plate 6.

According to the thermoelectric conversion module 1 configured as above, the sheet member 5 or the silicone oil grease 14 intervening between the heating plate 7a portion (high temperature surface S1) and the heat source side electrode portion 3 of the container 7 allows relative slide movement of the heating plate 7a portion and the heat source side electrode portion 3. For this reason, even if the container 7 thermally expands, the heating plate 7a portion of the container 7 is slid on the sheet member 5 or the silicone oil grease 14 to move slidingly in the plane direction so as to have no shearing stress acting on the thermoelectric semiconductors 2, heat source side electrode portion 3 and the radiation side electrode portion 4. Thus, even if the thermoelectric conversion module 1 is upsized, it neither destroys the fragile thermoelectric semiconductors 2 nor causes the peel-off on the joint surface. The interface having the sheet member 5 or the grease 14 intervening is pressurized from outside the container 7 by the differential pressure between the inside and the outside of the container 7 so that the thermal contact resistance on the interface can be reduced due to good adhesiveness. It is thereby possible to load the thermoelectric semiconductors 2 with a large temperature difference.

As described above, it is possible, by having the configuration for allowing thermal expansion of the members, to upsize the thermoelectric conversion module 1 so as to improve the substantial filling density of the thermoelectric semiconductors 2 and increase the power density (output per unit area). As the components of the thermoelectric conversion module 1 are accommodated in the container 7, the strength against a force from the outside becomes higher. As the components of the thermoelectric conversion module 1 are sealed in the container 7, it is possible to directly install and use the thermoelectric conversion module 1 in any atmosphere, such as an oxidizing atmosphere or a corrosive atmosphere.

Next, another embodiment of the present invention will be described. As to the embodiment described hereunder, the same components as those in the above embodiment will be given the same symbols and a detailed description thereof will be omitted.

As shown in FIG. 10 for instance, it is possible, by providing a bellows 15 on the side face portion 7b of the container 7, to deform the bellows 15 with the pressure exerted from outside the container 7 so as to promote the intimate contact between the heating side inner surface (high temperature surface S1) of the container 7 and the components of the thermoelectric conversion module 1 inside the container 7.

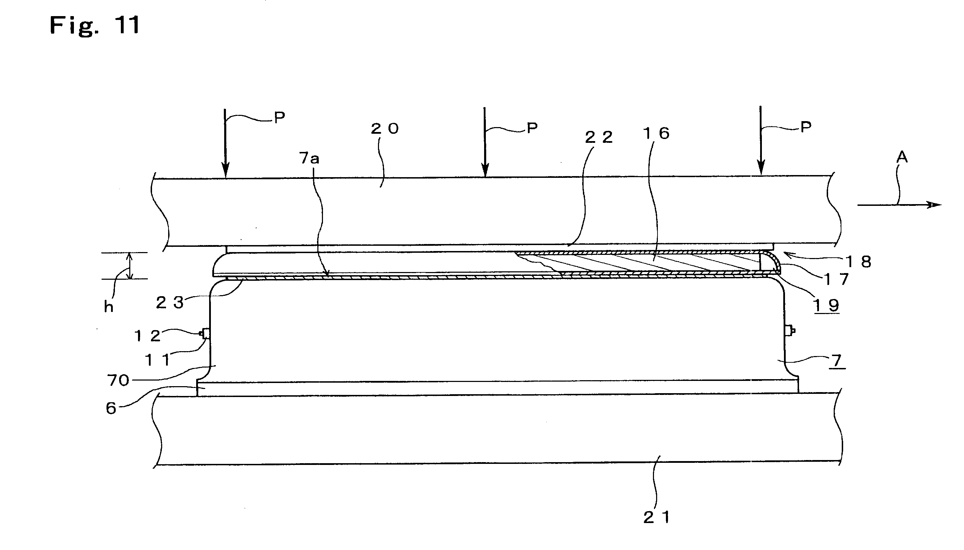

The thermoelectric conversion module 1 shown in FIG. 11 further includes a heat transfer cushion 18 having a low melting point material 16 showing a liquid state at the operating temperature and a shell 17 sealing the low melting point material 16 with flexibility for allowing deformation of the low melting point material 16. The example of FIG. 11 has the heat transfer cushion 18 on the heating plate 7a side of the container 7. As for its configuration, however, it is not limited to having the heat transfer cushion 18 on the heating plate 7a side of the container 7 but may also be have the heat transfer cushion 18 only on the cooling plate 6 side or on both the heating plate 7a side and the cooling plate 6 side.

As for the thickness of the shell 17, it is desirable to render it thin to be able to flexibly follow curved surface deformation (out-of-plane deformation) due to the temperature difference of the plane to which the shell 17 is opposed and from the viewpoint of reducing the thermal resistance. For instance, it is desirable to render it 20 $\mu$m to 100 $\mu$m (0.1 mm) or so. The material of the shell 17 to be selected is the one having the melting point higher than the operating temperature and a good coexistence property with the low melting point material 16 to be sealed in order to securely seal the low melting point material 16 at the operating temperature. In particular, it is desirable to use a metallic material having high heat conductivity. It is possible, for instance, to use aluminum (Al) and copper (Cu) at the operating temperature of 250°C or less, stainless steel (JIS SUS 304 or SUS 316 for instance) at the operating temperature of 400°C or less and INCONEL (Special Metals Corporation trademark) at the operating temperature of 600°C or less. The shell 17 of this embodiment is formed by using a thin metallic foil for instance. However, the material of the shell 17 is not limited to the metal.

The low melting point material 16 to be selected is the one having the melting point lower than the operating temperature, high heat conductivity and a good coexistence property with the shell 17. To be more precise, tin (Sn: melting point 232°C) and bismuth (Bi: melting point 271°C) are usable. Here, it is also possible to add particles of higher heat conductivity to the metal having the melting point lower than the operating temperature so as to obtain the low melting point material 16 satisfying the condition that it has the melting point lower than the operating temperature and high heat conductivity. For instance, it is possible, by adding the particles of copper (Cu) or tungsten (W) to bismuth, to increase seeming heat conductivity. In addition, it is also possible to use gallium (Ga: melting point 30°C) and indium (In: melting point 157°C) as the low melting point material 16 although they are not common because of high prices. However, the low melting point material 16 is not limited to the metal. For instance, other than the metal, molten salt (For example, $NaNO_3/KNO_3$) is usable as the low melting point material 16.

The heat transfer cushion 18 is made as follows for instance. For instance, the press forming is performed to one or both of two sheets of thin tabular metallic foil so as to have a clearance of 1 to 2 mm or so between the two sheets of metallic foil in the case of aligning the periphery of the two sheets. The low melting point material 16 formed like a sheet of the same thickness as the clearance is put into the clearance, and the two aligned sheets of metallic foil are sealed around the periphery by the method such as electron beam welding. Thus, the two sheets of metallic foil function as the shell 17. FIG. 11 shows an example of the case where the press forming is performed to only one of the two sheets of tabular metallic foil and the clearance for sealing the low melting point material 16 is formed. However, it is not limited to the configuration of FIG. 11. For instance, it is also possible to press-form both of the two sheets of tabular metallic foil and render the form of the two sheets of metallic foil configuring the shell 17 vertically symmetrical so as to form the clearance for sealing the low melting point material 16 inside the shell 17. It is also possible to powder the low melting point material 16 (powder of the metal exemplified above, for instance) and fill the powdered low melting point material 16 into the clearance formed inside the shell 17.

Here, it is desirable to have a clearance 19 made inside the shell 17 in the state of having the low melting point material 16 sealed therein. For instance, according to this embodiment, the dimensions of the sheet of the low melting point material 16 are smaller than the plane dimensions inside the shell 17 in order to secure the clearance 19 inside the shell 17. It is possible, by securing the clearance 19, to absorb cubical expansion when the low melting point material 16 melts and prevent the shell 17 from getting damaged by the cubical expansion of the low melting point material 16.

Furthermore, it is desirable to render the clearance 19 secured inside the shell 17 as a vacuum or an inert atmosphere in order to prevent the oxidization of the low melting point material 16. In the case of sealing surroundings of the shell 17 by the electron beam welding, it is performed in the vacuum atmosphere and so the inside of the shell 17 becomes vacuum by itself. In the case of rendering the inside the shell 17 as the inert atmosphere, the inert gas such as argon (Ar) or helium (He) is sealed in the shell 17 together with the low melting point material 16.

The larger the clearance of the two sheets of metallic foil configuring the shell 17, that is, a thickness h of the heat transfer cushion 18 is, the easier it becomes to flexibly follow the curved surface deformation due to the temperature difference of the plane to which the shell 17 is opposed so as to fill it between the two planes sandwiching the shell 17 well. It is desirable, however, to keep it at a necessary minimum because the thermal resistance of the heat transfer cushion 18 itself also becomes large. For this reason, the thickness h of the heat transfer cushion 18 is decided as appropriate according to a degree of deformation assumed as to the plane facing the shell 17.

In the example of FIG. 11, a heating duct is a heat source 20 for instance, and the heat transfer cushion 18 intervenes between the heat source 20 and the container 7. The cooling plate 6 of the thermoelectric conversion module 1 is joined to a cooling duct 21 for releasing a refrigerant inside by using a jointing material (adhesive or brazing filler metal for instance) having high heat conductivity. The force for pressing the thermoelectric conversion module 1 works on the heating duct as the heat source 20 and the cooling duct 21 as cooling means. For instance, it has the configuration in which the cooling duct 21 is fixed and the heat source 20 is movable, and the heat source 20 is moved to the cooling duct 21 side so as to have the pressurizing force P shown in FIG. 11 work thereon.

The low melting point material 16 sealed in the shell 17 is heated by the heat source 20 for instance and melts. As the shell 17 is flexible enough to allow the deformation of the low melting point material 16 in the liquid form, the heat transfer cushion 18 gets into intimate contact with the heating plane of the heat source 20 and the heating plate 7a of the container 7. And even if the heating plane of the heat source 20 and the heating plate 7a portion of the container 7 are deformed like the curved surface due to the temperature difference, the heat transfer cushion 18 flexibly follows the deformation and fills it between the heat source 20 and the heating plate 7a portion of the container 7 to prevent the clearance from being generated between the heat source 20 and the heating plate 7a portion of the container 7. Therefore, the heat transfer cushion 18 constantly keeps a good intimate contact state with the heat source 20 and the container 7.

Here, it is preferable to provide a second sheet member 22 in contact with the heat source 20 or the container 7 and slidable on one or both of the plane opposed to the heat source 20 and the plane opposed to the container 7 of the shell 17. In this case, even if the plane of the heat source 20 or the container 7 in contact with the heat transfer cushion 18 is relatively displaced by a large amount by the thermal expansion, the heat source 20 or the container 7 moves slidingly on the second sheet member 22. Therefore, it is possible to allow the thermal expansion displacement flexibly and prevent the shearing stress from working on the shell 17 so as to prevent the shell 17 from being destroyed. The second sheet member 22 is glued on the plane opposed to the heat source 20 of the shell 17 by using the jointing material (adhesive for instance) having high heat conductivity. The plane opposed to the container 7 of the shell 17 is glued on the container 7 by using a jointing material (adhesive for instance) 23 having high heat conductivity. As for the second sheet member 22, it is possible to use the same carbon sheet and polymer sheet as the above-mentioned sheet member 5 for instance.

According to the thermoelectric conversion module 1 shown in FIG. 11, the low melting point material 16 in the liquid form and the flexible shell 17 for sealing the low melting point material 16 follow the curved surface deformation (out-of-plane deformation) of the heat source 20 and the heating plate 7a portion of the container 7 and fill it well between the heat source 20 and the container 7 so as to prevent the clearance from being generated between the heat source 20 and the container 7. Therefore, the heat transfer cushion 18 constantly keeps a good intimate contact state with the heat source 20 and the container 7. Furthermore, the low melting point material 16 as a molten metal has high heat conductivity while the shell 17 is metallic and formed to be thin enough to achieve the flexibility. Therefore, the thermal resistance of the heat transfer cushion 18 itself is so low that it can convey the heat efficiently from the heat source 20 tn the thermoelectric semiconductors 2 in the container 7. It is possible, by using the heat transfer cushion 18, to alleviate requirements for flatness and surface roughness of the heating duct as the heat source 20 and the container 7. The flexible shell 17 having sealed the low melting point material 16 therein functions as a cushion and prevents the thermoelectric semiconductors 2 from being destroyed by the pressurizing force P working on the thermoelectric conversion module 1.

Furthermore, in the case where the heating duct as the heat source 20 thermally expands, the contact surface of the heat source 20 with the thermoelectric conversion module 1 is slid on the second sheet member 22 to move slidingly in the plane direction (arrow A direction in FIG. 11) so as to release the shearing stress acting on the shell 17 and prevent destruction of the shell 17. It is thereby possible to allow the thermal expansion displacement due to the temperature difference during the operation and stop of the heating duct. It is also possible to reduce the thermal resistance of the interface having the carbon sheet as the second sheet member 22 intervening to 1/10 or less of the case of having no carbon sheet. It is possible, as described above, to increase the temperature difference which the thermoelectric conversion module 1 can be loaded with and improve power generation performance of the thermoelectric conversion module 1. To be more specific, it is possible to improve substantial energy conversion efficiency. It is thereby possible to reduce a power generation unit price of the thermoelectric conversion system.

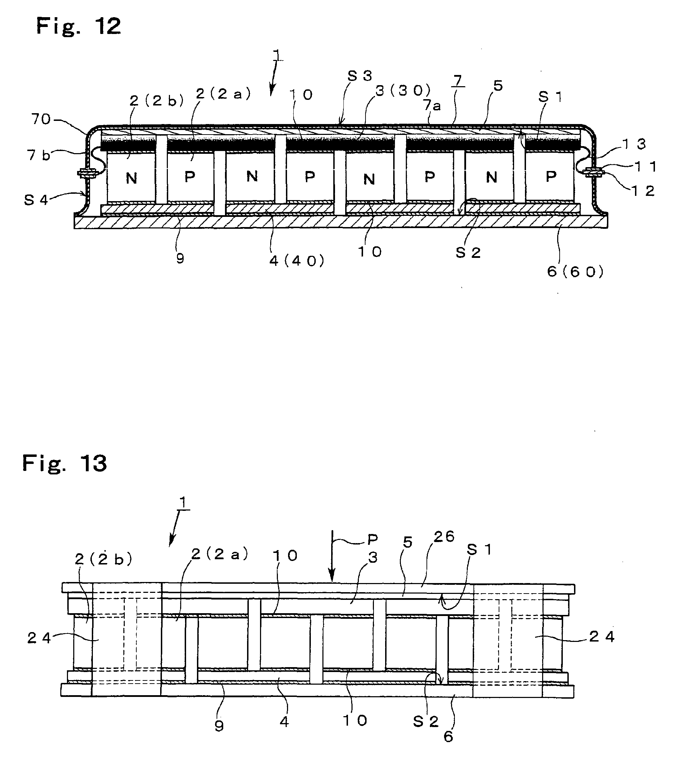

The thermoelectric conversion module 1 shown in FIG. 12 has a heat receiving plane S3 for receiving the heat by radiation from the heat source not shown. An emissivity of a circumferential surface portion of the container 7 as a side face S4 against the heat receiving plane S3 is smaller than the emissivity of the heat receiving plane S3. As the emissivity of the plane becomes smaller, it becomes more difficult to absorb the heat and more difficult to get heated. Inversely, as the emissivity of the plane becomes larger, it becomes easier to absorb the heat and easier to get heated. Therefore, it becomes easier to heat the heat receiving plane S3 by setting the emissivity of the heat receiving plane S3 (top face) of the container 7 larger so as to increase the temperature difference which the thermoelectric semiconductors 2 are loaded with. On the other hand, it becomes more difficult to heat the side face S4 of the container 7 by setting the emissivity of the side face S4 of the container 7 smaller so as to prevent a heat drop of the thermoelectric semiconductors 2 from becoming smaller. The power generation performance of the thermoelectric conversion module 1 is proportional to approximately a square of the temperature difference which the thermoelectric semiconductors 2 are loaded with. Therefore, it is possible to improve the power generation performance of the thermoelectric conversion module 1 significantly by setting different emissivities on the heat receiving surface S3 and the side face S4 as described above.

The emissivity depends not only on the materials but also on a surface finishing. It also depends on a degree of oxidization in the case of using it in the air. Therefore, the emissivity of the surface of the container 7 can be set to a target value by selecting the materials configuring the container 7 or selecting one or a plurality of sheathings covering a part or all of the container material or according to the surface finishing, that is, the degree of surface roughness of the container 7 for instance. It is also possible, as a matter of course, to set the emissivity of the surface of the container 7 to the target value by combining some or all of the above-mentioned measures. The sheathing can be attached to a basis material by coating, vapor deposition, plating, painting or pasting. The emissivity can be reduced by performing a mirror finish to the container 7 surface, and can be increased by performing a rough finish leaving minute convexities and concavities on the container 7 surface.

The above-mentioned embodiment is an example of the preferred embodiments of the present invention. However, it is not limited thereto but various deformed embodiments may be implemented to the extent of not deviating from the gist of the present invention. For instance, as for the above-mentioned embodiment, a description was mainly given as to the configuration in which the airtight container 7 is adopted and the inside of the container 7 accommodating the components such as the thermoelectric semiconductors 2 is a vacuum or a reduce-pressure atmosphere. However, it does not have to be the airtight container 7 from the viewpoint of achieving integration of the thermoelectric conversion module 1 and maintenance of the strength. It is also feasible to place the coupling plate on the entire periphery of the heating plate and cooling plate, adopt a non-airtight container or partially couple it with the coupling plate. For instance, as shown in FIG. 13, a heating plate 26 is connected to the cooling plate 6 contacting the radiation side electrode portion 4 at least at two points or preferably a few or more points by using a coupling plate 24 so as to have the pressurizing force P work on the thermoelectric conversion module 1 sandwiched between the heating plate 26 and the cooling plate 6. Thus, the sheet member 5 is pressed onto the heat source side electrode portion 3, and is integrally held with the thermoelectric semiconductors 2 and the radiation side electrode portion 4. It is also feasible, during the use, to sandwich the thermoelectric conversion module 1 between the heating duct as the heat source 20 and the cooling duct 21 and adjust the distance between the heating duct and the cooling duct 21 so as to have a proper pressurizing force work on the thermoelectric conversion module 1.

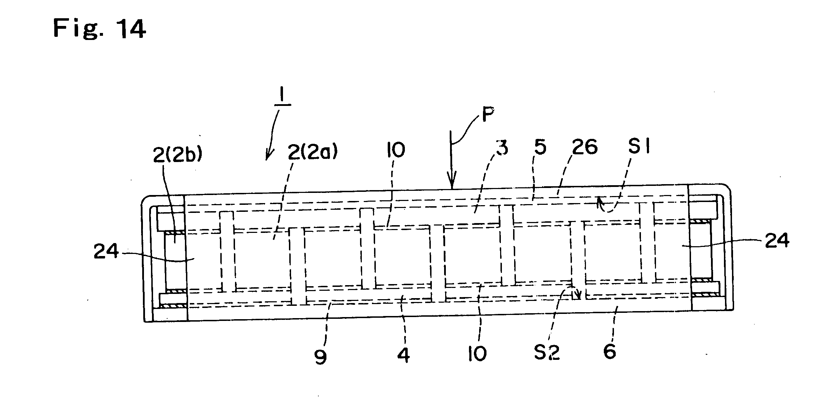

As shown in FIG. 14, it is also possible to expand the range of the coupling plate 24 coupling the heating plate 26 and cooling plate 6 and place the coupling plate 24 on the substantially entire periphery so as to configure the non-airtight container between the heating plate and the cooling plate. It can be easily formed by joining a wide coupling plate 24 to the heating plate 26 and cooling plate 6 by means of welding, adhesion or brazing respectively or by joining to the cooling plate 6 one plate having four coupling plates 24 placed around the heating plate 26 and integrally formed by bending work. Furthermore, it is also possible to make a through-hole on a part of the side of the lid 70 configuring the aforementioned airtight container and thereby render it non-airtight.

In this configuration, the heat source side electrode portion 3 is not directly joined to the heating plate 26. The sheet member 5 intervening between the heating plate 26 and the heat source side electrode portion 3 allows the relative slide movement of the heating plate 26 and the heat source side electrode portion 3. For this reason, even if the heating plane of the heating plate 26 thermally expands, the heating plane of the heating plate 26 is slid on the sheet member 5 to move slidingly in the plane direction so as to have no shearing stress acting on the thermoelectric semiconductors 2, heat source side electrode portion 3 and the radiation side electrode portion 4. Thus, even if the thermoelectric conversion module 1 is upsized, it neither destroys the fragile thermoelectric semiconductors 2 nor causes the peel-off on the joint surface. The interface having the sheet member 5 intervening is in good intimate contact due to the pressurizing force P working on the thermoelectric conversion module 1 so that the thermal contact resistance on the interface can be reduced. It is thereby possible to load the thermoelectric semiconductors 2 with a large temperature difference. It is also possible to upsize the thermoelectric conversion module 1 so as to improve the substantial filling density of the thermoelectric semiconductors 2 and increase the power density (output per unit area).

## Claims

1.    A thermoelectric conversion module which includes
at least a pair of thermoelectric semiconductors,
a heat source side electrode portion installed on a plane of a high-temperature heat source side of the thermoelectric semiconductors for electrically connecting the thermoelectric semiconductors in series,
a radiation side electrode portion installed on a plane of a low-temperature heat source side of the thermoelectric semiconductors for electrically connecting the thermoelectric semiconductors in series,
a heating plate for covering the heat source side electrode portion and receiving heat from the high-temperature heat source, and
a cooling plate for covering the radiation side electrode portion and conveying the heat to the low-temperature heat source, the thermoelectric conversion module, comprising:

a sliding member having high heat conductivity intervening at least between the heat source side electrode portion and the heating plate; and
a coupling plate for coupling the cooling plate to the heating plate and sandwiching the thermoelectric semiconductors and the electrode portions between the cooling plate and the heating plate via the sliding member so as to integrate them,

wherein the sliding member is pressed onto the heat source side electrode portion and held integrally therewith by a pressurizing force working between the heating plate and the cooling plate, and the sliding member in the pressurized state allows relative sliding between the sliding member and the heat source side electrode portion or the heating plate.

2.    The thermoelectric conversion module according to claim 1, wherein the heating plate and the cooling plate have all their surrounding side faces covered by the coupling plate to configure an airtight container for sealing a space between the heating plate and the cooling plate, and a pressure in the container is lower than a pressure outside the container so as to have the pressurizing force exerted by a differential pressure.

3.    The thermoelectric conversion module according to claim 1 or 2, wherein the sliding member is a sheet member having a low friction coefficient.

4.    The thermoelectric conversion module according to claim 3, wherein the sheet member is an electrically insulating polymer sheet.

5.    The thermoelectric conversion module according to claim 3, wherein the sheet member is a carbon sheet, and an electrical insulating material or an electrical insulating layer intervenes between the electrode portion and the sheet member.

6.    The thermoelectric conversion module according to claim 2, wherein grease is used as the sliding member.

7.    The thermoelectric conversion module according to any one of claims 2 - 6, wherein inside of the container is a vacuum.

8. The thermoelectric conversion module according to any one of claims 2 - 7, wherein the inside of the container is filled with an inert atmosphere or a reducing atmosphere.

9. The thermoelectric conversion module according to any one of claims 2 - 8, wherein the container comprises a bellows capable of expanding and contracting an interval between the heating plate and the cooling plate in the coupling plate portion, and deforms the bellows with the pressurizing force working between the heating plate and the cooling plate so as to put the heating plate and the heat source side electrode portion in intimate contact via the sliding member.

10. The thermoelectric conversion module according to any one of claims 1 - 9, wherein an emissivity of a surface of the coupling plate is smaller than the emissivity of a surface of the heating plate facing the high-temperature heat source side.

11. The thermoelectric conversion module according to any one of claims 1 - 10, comprising a heat transfer cushion having a low melting point material showing a liquid state at an operating temperature of the thermoelectric conversion module and a shell with flexibility for sealing the low melting point material therein and allowing deformation of the low melting point material in the liquid state at least either between the heating plate and the high-temperature heat source contacting the heating plate or between the cooling plate and the low-temperature heat source contacting the cooling plate.

12. The thermoelectric conversion module according to claim 11, wherein a second sliding member made of the heat-conductive sheet member having a low friction coefficient intervenes between the heat transfer cushion and the heating plate or the cooling plate.

13. The thermoelectric conversion module according to claims 1 or 2, wherein the heat source side electrode portion is constituted by functionally graded materials having an electrode layer and an electrical insulating layer, and the sliding member is the carbon sheet.

14. The thermoelectric conversion module according to claim 13, wherein a mica sheet further intervenes between the heat source side electrode portion and the carbon sheet.

Fig. 1

Fig. 2

Fig. 3

Fig. 4

Fig. 5

Fig. 6

## Fig. 7

## Fig. 8

Fig. 9

Fig. 10

Fig. 11

## Fig. 12

N P N P N P N P

## Fig. 13

Fig. 14

Fig. 15

EP 1 615 274 A2

Fig. 16

103(103a)

102

101

| N | P | N | P | N | P | N | P |

102

103(103b)

Fig. 17

103(103a)

104

101

| N | P | N | P | N | P | N | P |

104

103(103b)